# FASCICULE DE BREVET EUROPEEN

(11) **EP 0 631 150 B1**
(45) Date de publication et mention de la délivrance du brevet: **23.12.1998**
(21) Numéro de dépôt: 94401396.0
(22) Date de dépôt: 22.06.1994
(51) Int. Cl.: G01R 33/24

(54) **Sonde à RMN à oscillateur en boucle**
Magnetische Kernresonanz-Sonde mit Oszillator-Regelkreis
NMR sonde with controlled oscillator loop

(30) Priorité: 24.06.1993 FR 9307691
(43) Date de publication de la demande: 28.12.1994
(73) Titulaire: COMMISSARIAT A L'ENERGIE ATOMIQUE, 75015 Paris Cédex 15 (FR)
(72) Inventeur: Glenat, Henri, F-38700 Corenc (FR)
(74) Mandataire: Signore, Robert

(56) Documents cités:
- EP-A- 0 296 005
- EP-A- 0 345 118
- EP-A- 0 359 598
- EP-A- 0 445 017
- EP-A- 0 451 054
- WO-A-92/08996

## Description

### Domaine technique

La présente invention a pour objet une sonde de magnétomètre à RMN (Résonance Magnétique Nucléaire) à oscillateur en boucle. Elle trouve une application dans la mesure précise des champs magnétiques, notamment du champ magnétique terrestre.

### Etat de la technique

La sonde de l'invention est d'un type connu, décrit par exemple dans les demandes de brevet français FR-A-1 447 226 et FR-A-2 098 624. Le principe de fonctionnement de ces sondes peut être rappelé brièvement.

Lorsqu'un échantillon liquide, dont les noyaux atomiques ont un moment magnétique et un moment cinétique non nuls, est soumis à un champ magnétique, les moments magnétiques nucléaires ont tendance à s'aligner parallèlement ou antiparallèlement au champ. La différence d'énergie entre ces deux états définit une énergie de résonance nucléaire ou une fréquence de résonance nulcéaire, laquelle tombe généralement dans la gamme des basses fréquences, de l'ordre du millier de Hertz.

Cependant, avec les champs habituels, la polarisation nucléaire globale (positive ou négative) présentée par l'échantillon reste faible et difficilement détectable.

L'effet OVERHAUSER-ABRAGAM permet d'augmenter sensiblement cette polarisation. A cette fin, on dissout une substance paramagnétique appropriée dans un solvant, cette substance étant choisie pour posséder un électron non apairé donnant naissance à un niveau électronique excité présentant une structure hyperfine à quatre sous-niveaux. En général, la fréquence de pompage permettant de porter la substance sur l'un de ces sous-niveaux électroniques est située dans la gamme des hautes fréquences, de l'ordre de quelques dizaines de MégaHertz.

Le couplage dipolaire entre le spin électronique de la substance paramagnétique ainsi excitée et le spin nucléaire du solvant augmente considérablement la polarisation de ce dernier. Selon la transition électronique excitée, on favorise la polarisation nucléaire positive ou la polarisation nucléaire négative du solvant.

Cette technique est encore perfectionnée par la mise en oeuvre d'un "double effet". Une première solution radicalaire (c'est-à-dire un solvant avec une substance paramagnétique) est soumise à une haute fréquence qui sature le niveau électronique favorisant la polarisation positive du solvant, alors qu'une deuxième solution radicalaire est soumise à une haute fréquence qui sature le niveau électronique favorisant la polarisation négative du solvant.

Dans le premier cas, un signal d'excitation à la fréquence de résonance nucléaire appliqué à l'échantillon sera absorbé par celui-ci alors que, dans le second cas, un signal d'excitation à cette même fréquence provoquera une émission stimulée à la fréquence de résonance. Des enroulements de prélèvement disposés autour de la première et de la seconde solutions délivreront alors des tensions de même fréquence mais de phases opposées. Un branchement sur un amplificateur différentiel permettra d'en faire la somme. Tous les signaux parasites induits dans ces enroulements, et qui, eux, ont la même phase, seront annulés.

Une telle sonde à double effet peut fonctionner avec deux solutions différentes et une seule fréquence d'excitation, à condition que les spectres d'absorption des deux solutions soient décalés l'un par rapport à l'autre de telle sorte que la fréquence unique corresponde à la polarisation positive pour l'un et à la polarisation négative pour l'autre.

Mais une sonde à double effet peut fonctionner aussi avec une même solution répartie en deux échantillons et en appliquant à ces deux échantillons deux fréquences différentes, pour saturer séparément les deux sous-niveaux de la substance paramagnétique.

Enfin, par un dernier perfectionnement, le signal délivré par la sonde, qui est à la fréquence de résonance nucléaire, peut être réinjecté comme signal d'excitation des échantillons,dans un montage en boucle qui fonctionne alors en oscillateur. On obtient alors une sonde du type "oscillateur à couplage de spins".

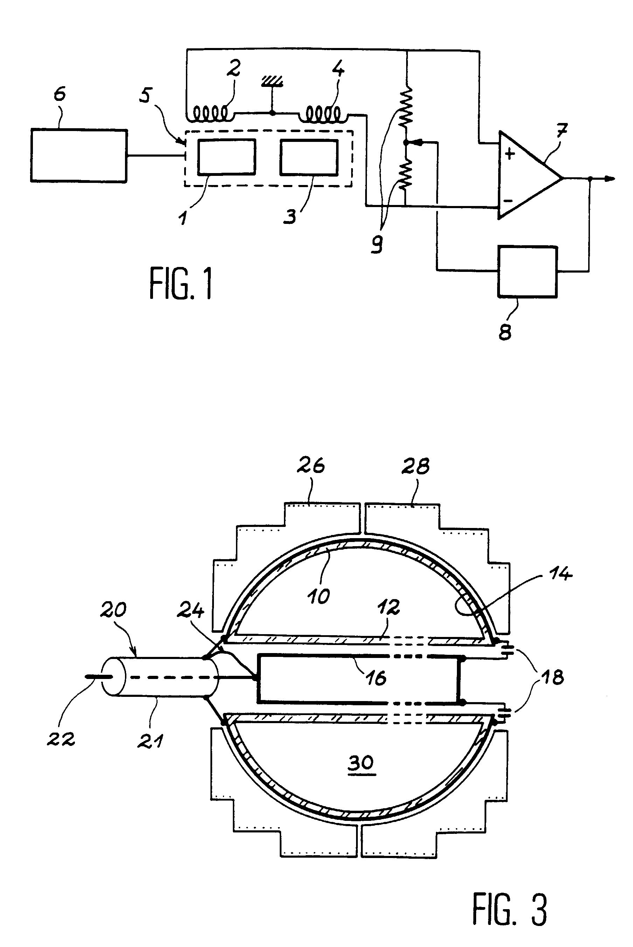

Les figures 1 à 3 annexées illustrent cet art antérieur connu.

Sur la figure 1, tout d'abord, on voit une sonde comprenant un premier flacon 1 à polarisation positive avec son enroulement basse fréquence 2, un second flacon 3 à polarisation négative avec son enroulement basse fréquence 4, un résonateur unique haute fréquence 5 entourant les deux flacons et un générateur haute fréquence 6 alimentant ce résonateur. Les deux enroulements 2 et 4 sont montés en série-opposition et sont reliés aux entrées positive et négative d'un amplificateur différentiel 7, dont la sortie est rebouclée, par l'intermédiaire d'un régulateur de niveau référencé 8, sur les enroulements basse fréquence, le bouclage s'effectuant à travers un pont résistif d'équilibrage 9.

La fréquence du signal délivré par un tel oscillateur est égale à la fréquence de résonance nucléaire, laquelle est directement proportionnelle au champ magnétique ambiant, le facteur de proportionnalité étant égal au rapport gyromagnétique des noyaux atomiques.

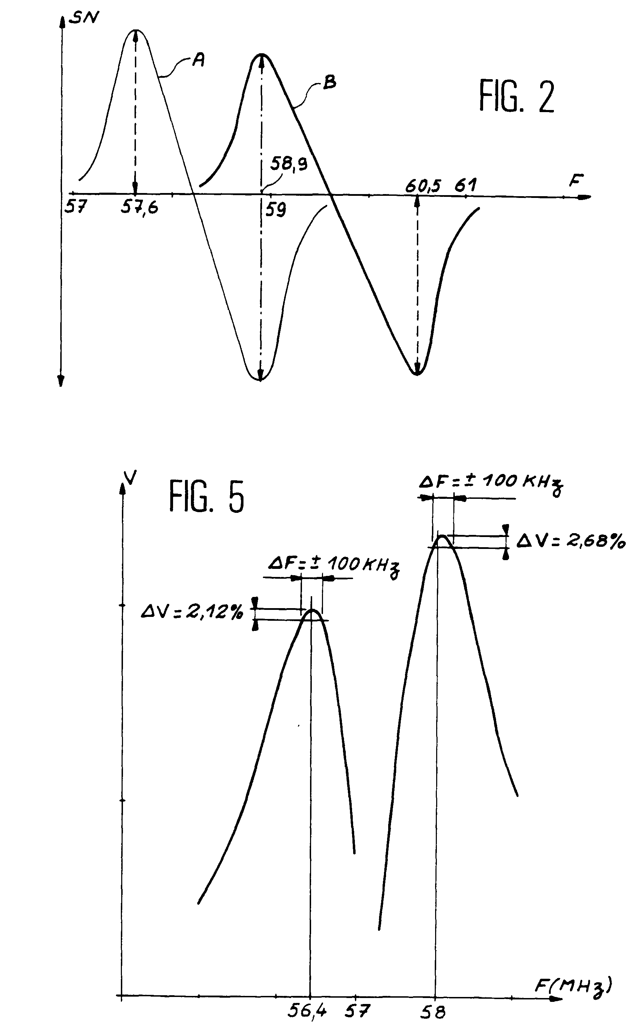

La figure 2 montre deux signaux nucléaires SN obtenus pour deux solutions différentes A et B, en fonction de la haute fréquence F. Pour une solution de TANO N 15 deutérié à M/1000 dans le diméthoxéthane (DME) avec 8% d'eau (solution A), on trouve une première transition à 57,60 MHz et une seconde transition à 58,90 MHz. Pour le même radical mais en solution dans du méthanol (solution B), on trouve 58,90 MHz pour la première transition et 60,50 MHz pour la seconde.

Ces caractéristiques sont intéressantes car elles permettent, avec une seule valeur de fréquence (58,90 MHz) de saturer deux transitions opposées et d'obtenir l'inversion de la résultante macroscopique dans un des solvants par rapport à l'autre.

De nombreux modes de réalisation de ces sondes ont été décrits dans les deux documents déjà cités ainsi que dans FR-A-2 583 887, FR-A-2 610 760 et FR-A-2 658 955.

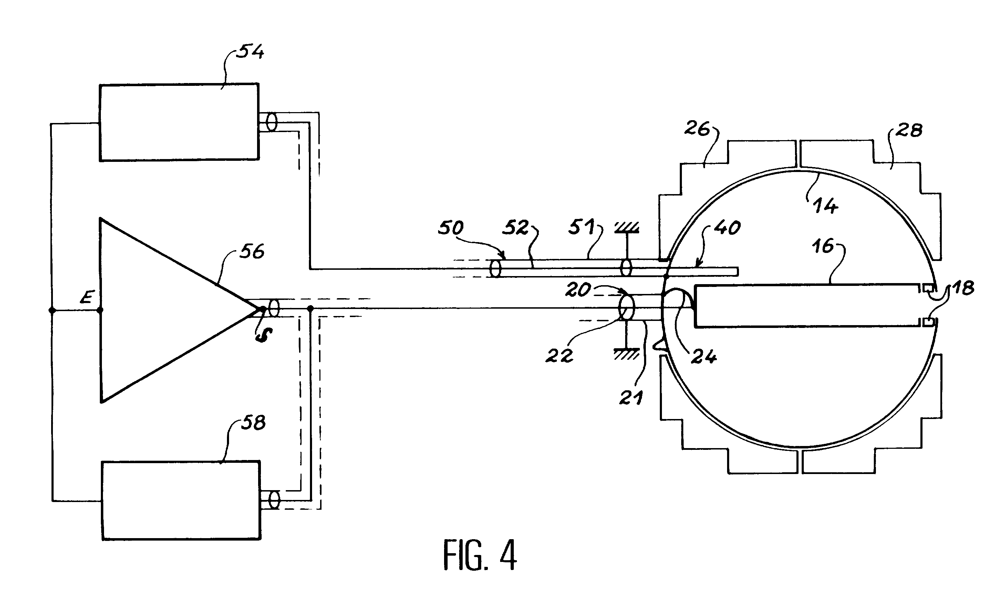

A titre d'exemple, la figure 3 représente une sonde qui comprend un flacon 10, par exemple en Pyrex, avec une forme sphérique (mais une forme conique, cylindrique ou autre est possible). Un tube central 12, également en Pyrex, est disposé sur l'axe de la sonde. Le flacon sphérique 10 est recouvert extérieurement d'une couche conductrice 14, par exemple une peinture à l'argent recuite à 550°C. Cette couche peut n'être pas continue mais divisée en secteurs (1 à 8 par exemple) pour éviter la formation de courants de FOUCAULT lors du déplacement de la sonde dans le champ à mesurer. Le tube central 12 contient un cylindre conducteur creux 16, par exemple en argent, qui est l'âme centrale du résonateur et qui est raccordée à la surface sphérique conductrice 14 par des condensateurs amagnétiques 18. Ces condensateurs sont réglables pour permettre de régler la fréquence du résonateur coaxial ainsi formé.

Ce résonateur est connecté à un câble coaxial 20, par exemple d'impédance 50 Ohms, formé par un conducteur extérieur 21 et un conducteur central 22. Le conducteur extérieur 21 est relié au conducteur extérieur 14 du résonateur et le conducteur central 22 est relié à l'âme centrale 16. Une boucle 24 permet une adaptation du résonateur à l'impédance du câble (50 Ohms par exemple) en reliant le conducteur extérieur 21 du câble à l'âme centrale 16.

Le résonateur est complétement entouré par deux enroulements 26, 28 qui présentent, intérieurement, une forme de calotte sphérique et, extérieurement, une forme en escaliers (les zones peu actives ayant été supprimées pour éviter un poids excessif). Les deux enroulements 26, 28 sont identiques en forme et placés symétriquement par rapport au plan médian de la sonde et sont connectés soit en série-série, soit en série-opposition.

Dans d'autres modes de réalisation, le résonateur peut comprendre deux flacons alimentés par un seul générateur ou bien comprendre deux générateurs haute-fréquence distincts alimentant deux résonateurs accordés sur deux fréquences de résonance différentes.

Quelle que soit la variante utilisée, ces sondes de l'art antérieur présentent des inconvénients.

Le premier inconvénient est lié à un glissement de la fréquence d'accord, qui se traduit par un taux d'ondes stationnaires variable. Il en résulte une fluctuation de la puissance dissipée dans le résonateur, entraînant une détérioration des performances de la sonde (apparition d'une anisotropie, baisse du rapport signal/bruit, mauvais fonctionnement de l'amplificateur différentiel d'entrée). Les causes de ce glissement de la fréquence d'accord du résonateur sont doubles :
a) Les condensateurs qui participent au réglage de l'accord du résonateur sur la fréquence du générateur haute-fréquence, n'ont pas un très faible coeffficient de température (0±20 ppm/°C) ; le document FR-A82 658 955 déjà cité propose d'utiliser une capacité d'accord répartie pour résoudre en partie ce problème, mais les nouvelles améliorations apportées au résonateur pour diminuer la consommation (augmentation du coefficient de qualité jusqu'à environ 500) ont fait ressurgir ce problème ;
b) les dimensions géométriques des éléments constituant le résonateur varient : flacon en pyrex, dépôt d'argent, soudures, âme centrale, pattes de sortie des condensateurs ou boucle d'adaptation, participent au glissement de fréquence d'accord du résonateur.

Un deuxième inconvénient concerne les difficultés de fabrication. Du fait des variations de dimensions d'un résonateur à l'autre, il est difficile de reproduire la capacité à utiliser pour une fréquence d'accord donnée. Par ailleurs, la tolérance sur les capacités n'est pas assez serrée (±5 à 10%). Il faut une précision du 1/1000 pour caler la fréquence du résonateur sur la fréquence délivrée par le générateur haute fréquence (avec une précision de ±1kHz sur 60 MHz).

Enfin, un dernier inconvénient vient du rendement du générateur haute fréquence. Les améliorations sur le résonateur ont permis de diminuer de façon très significative la consommation du résonateur. La puissance nécessaire est maintenant de l'ordre de quelques dizaines de milliwatts. Dans ces conditions, il est très difficile, voire impossible, d'obtenir un bon rendement (il reste inférieur à 20%), ce qui ne permet pas de tirer pleinement parti de l'amélioration du résonateur.

La présente invention a justement pour but de remédier à tous ces inconvénients.

### Exposé de l'invention

A cette fin, l'invention propose de remplacer le générateur haute fréquence par des moyens constituant un oscillateur en boucle, qui est automatiquement asservi à la fréquence de résonance du résonateur.

Ces moyens comprennent une boucle de prélèvement placée au moins en partie dans le résonateur et un amplificateur haute fréquence à large bande ayant une entrée reliée à ladite boucle par un conducteur coaxial et une sortie reliée au conducteur coaxial d'alimentation du résonateur.

Etant, par construction, asservi à la fréquence de résonance du résonateur, l'oscillateur ainsi constitué alimente nécessairement à la fréquence correcte le résonateur, quelles que soient les dérives, les fluctuations, les variations d'origines diverses.

Dans la définition qui précède, il faut comprendre que le résonateur en question n'est en rien limité à une forme ni à un flacon ni à une solution particulière. Il peut comprendre un ou plusieurs flacons, contenant une ou plusieurs solutions radicalaires.

Dans une variante avantageuse, l'amplificateur est associé à des moyens de contrôle automatique de gain.

Dans une autre variante avantageuse, la sonde comprend en outre des moyens de déphasage insérés entre le conducteur coaxial de prélèvement et l'entrée de l'amplificateur.

### Brève description des dessins

- la figure 1, déjà décrite, représente schématiquement une sonde à RMN selon l'art antérieur ;
- la figure 2, déjà décrite, montre les variations d'un signal nucléaire pour deux solutions radicalaires différentes ;
- la figure 3, déjà décrite, montre un mode de réalisation d'un résonateur connu à un seul flacon ;
- la figure 4, montre un mode de réalisation d'une sonde selon l'invention ;
- la figure 5 montre la forme des raies de résonance pour deux fréquences différentes ;
- la figure 6 montre un circuit d'étalonnage du gain de l'amplificateur fonctionnant en boucle ouverte, mais ne concerne pas la présente invention ;
- la figure 7 montre une première position possible pour la boucle de prélèvement ;
- la figure 8 montre une seconde position possible pour cette même boucle de prélèvement ;
- la figure 9 illustre un mode de réalisation compact d'une boucle à double fonction (adaptation, prélèvement) ;
- la figure 10 montre une boucle pouvant pivoter autour de son axe.

### Exposé détaillé de modes de réalisation

La sonde représentée sur la figure 4 comprend un résonateur à un seul flacon, comme sur la figure 3 (les références identiques sur ces deux figures désignent les mêmes éléments). Mais, selon l'invention, la sonde de la figure 4 comprend une boucle de prélèvement 40 placée dans le résonateur et reliée à un conducteur coaxial 50 comprenant un conducteur extérieur 51 porté à la masse et un conducteur central 52. Le conducteur coaxial 50 est relié à un circuit de réglage de phase 54, lequel est relié à l'entrée E d'un amplificateur haute-fréquence à large bande 56. La sortie S de cet amplificateur est reliée au coaxial 20 d'alimentation du résonateur. On trouve, en outre, en parallèle sur l'amplificateur, un circuit 58 de contrôle automatique du gain servant à asservir le résonateur en puissance.

Le fonctionnement de ce dispositif est le suivant. La boucle 40 prélève par induction une partie du champ électromagnétique présent dans le résonateur. Le signal prélevé est amplifié par l'amplificateur 56 puis réinjecté dans le résonateur. Pour compenser les éventuelles différences de longueur entre les deux conducteurs coaxiaux 20 et 50 ou tout autre type de déphasage et assurer une réinjection avec une phase correcte, le déphaseur 54 a été prévu.

Les moyens constitués par le résonateur 14-16, la boucle 40, le conducteur 50, le déphaseur 54, l'amplificateur 56, le conducteur 20 et à nouveau le résonateur 14-16, forment une boucle qui ne peut osciller que sur la fréquence de résonance du résonateur. Le taux d'ondes stationnaires est donc toujours nul, par construction même, et ceci quelles que soient la température, la position du résonateur dans l'espace, la position de la bulle de dilatation, etc...

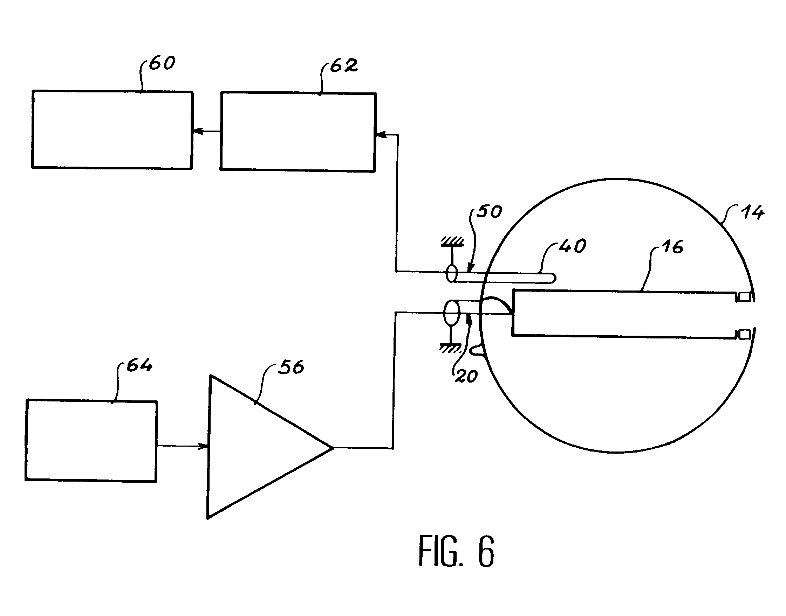

La figure 5 donne l'allure du spectre haute fréquence d'une solution radicalaire TANO N15 deutérié à M/1000 dans le tétrahydrofurane (THF) comme solvant. Le spectre HF montre encore deux raies à 56,4 MHz et 58 MHz, assez larges pour autoriser un décalage de fréquence relativement important de ±100 KHz n'entraînant qu'une faible baisse de l'amplitude du signal nucléaire (environ 3%). Par ailleurs, il a été vérifié qu'un décalage de fréquence d'excitation haute fréquence des transitions (±100 kHz) n'influence en rien la fréquence de précession (fréquence de LARMOR) et ne se traduit pas non plus par une augmentation du bruit.

A titre purement explicatif, le Demandeur a réalisé un résonateur sphérique d'un diamètre de 74 mm, avec des conducteurs coaxiaux d'impédance 50 Ohms. Les condensateurs d'accord avaient une valeur fixe. La boucle de prélèvement avait une longueur de 20 mm et une largeur de 3 mm.

La figure 6 montre un montage en boucle ouverte permettant de mesurer la puissance prélevée par la boucle disposée dans le résonateur. Le second conducteur coaxial 50 est relié à un wattmètre 62 terminé par une charge adaptée 60. L'amplificateur 56 est alimentée par un synthétiseur haute fréquence 64.

La puissance prélevée qui a été mesurée est de 25 mW pour une puissance injectée de 100 mW dissipée dans le résonateur. Cette puissance est largement suffisante pour entretenir l'oscillation haute fréquence.

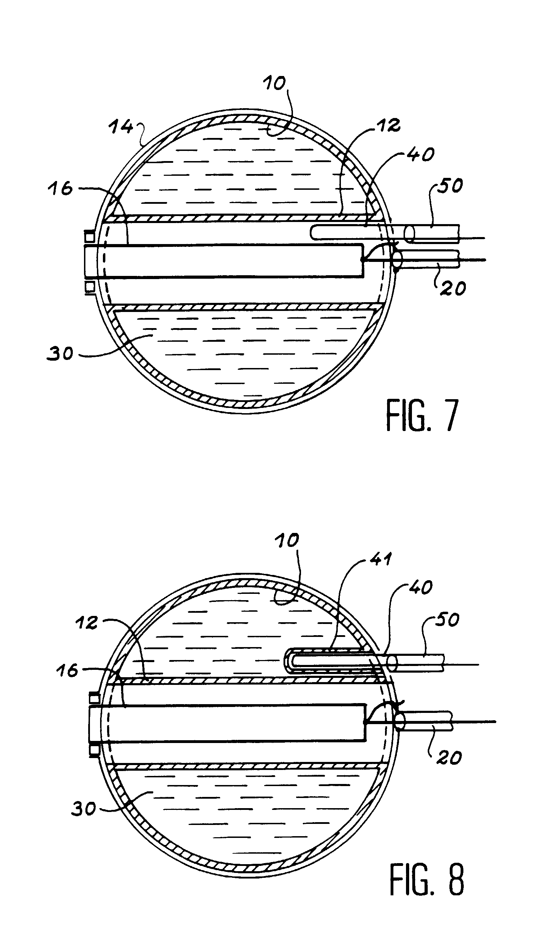

Les figures 7 et 8 montrent comment on peut disposer la boucle de prélèvement 40 dans le résonateur. Sur la figure 7, cette boucle est insérée entre l'âme conductrice 16 et le tube intérieur 12 du flacon. Sur la figure 8, un tube 41, par exemple en pyrex, est introduit dans la solution radicalaire et la boucle de prélèvement 40 est placée à l'intérieur du tube 41.

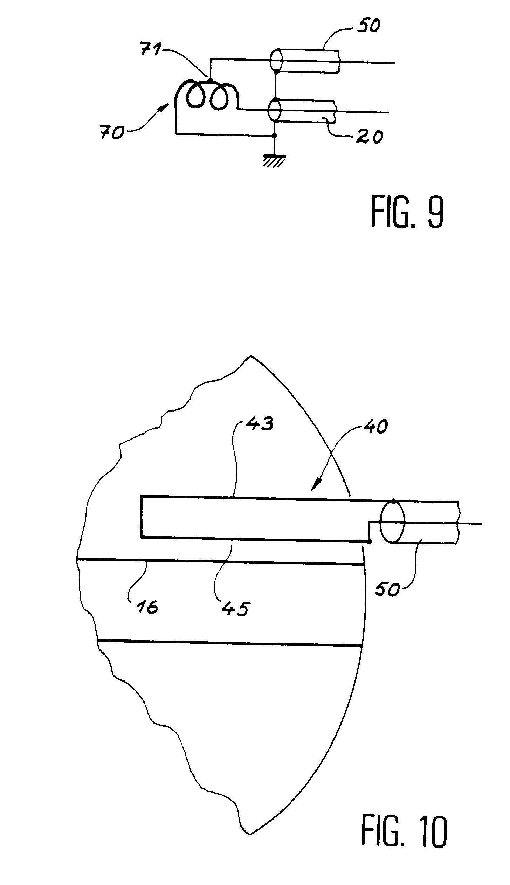

La figure 9 montre un mode de réalisation où un enroulement unique 70 sert à la fois de boucle d'adaptation et de boucle de prélèvement. Cet enroulement 70 comprend deux spires avec un point milieu 71. Les deux spires sont reliées en parallèle sur le premier conducteur coaxial 20 et le point milieu 71 à l'âme du second conducteur coaxial 50.

La figure 10, enfin, montre une boucle 40 formée par deux brins parallèles 43, 45, la boucle pouvant pivoter autour de son axe longitudinal. Ce pivotement permet de régler le couplage à la cavité.

Un autre mode de réglage de couplage peut être obtenu en déplaçant la boucle parallèlement à elle-même, pour l'enfoncer plus ou moins dans le résonateur.

## Revendications

1. Sonde à résonance magnétique nucléaire comprenant :
- au moins un résonateur haute fréquence (14, 16) contenant au moins un flacon (10, 12) à au moins une solution radicalaire (30),
- un premier conducteur coaxial (20) relié au résonateur, et
- des moyens d'alimentation de ce premier conducteur coaxial (20) à la fréquence de résonance du résonateur (14, 16),
cette sonde étant caractérisée par le fait que les moyens d'alimentation sont constitués par une boucle conductrice de prélèvement (40) placée au moins en partie dans le résonateur (14, 16) et par un amplificateur haute fréquence à large bande (56) ayant une entrée (E) reliée à ladite boucle (40) par un second conducteur coaxial (50) et une sortie (S) reliée audit premier conducteur coaxial (20), l'ensemble amplificateur (56), premier conducteur coaxial (20), résonateur (14, 16), boucle de prélèvement (40), second conducteur coaxial (50), constituant un oscillateur en boucle, asservi à la fréquence de résonance du résonateur (14, 16).

2. Sonde selon la revendication 1, caractérisée par le fait que les moyens d'alimentation comprennent, en outre, des moyens (58) de contrôle automatique du gain de l'amplificateur (56).

3. Sonde selon la revendication 1, caractérisée par le fait que les moyens d'alimentation comprennent en outre des moyens de déphasage (54) insérés entre le second conducteur coaxial (50) et l'entrée (E) de l'amplificateur (56).

4. Sonde selon l'une quelconque des revendications 1 à 3, caractérisée par le fait que le flacon comprend un tube intérieur cylindrique (12) et une paroi extérieure (10), le résonateur étant constitué, d'une part, par une âme conductrice (16) occupant le tube intérieur (12) du flacon et d'autre part, une couche conductrice (14) déposée sur la paroi extérieure du flacon, l'âme conductrice (16) et la couche conductrice (14) étant reliées, d'un côté de la sonde, à au moins un condensateur d'accord (18) et, de l'autre, au premier conducteur coaxial (20) par une boucle d'adaptation d'impédance (24).

5. Sonde selon la revendication 4, caractérisée par le fait que la boucle de prélèvement (40) est disposée entre l'âme conductrice (16) et le tube intérieur (12) du flacon.

6. Sonde selon la revendication 4, caractérisée par le fait que la boucle de prélèvement (40) est disposée dans un tube (41) pénétrant dans la solution radicalaire entre le tube intérieur cylindrique (12) et la paroi extérieure (10).

7. Sonde selon l'une quelconque des revendications 1 à 6, caractérisée par le fait que la boucle de prélèvement (40) est formée de deux brins conducteurs (43, 45) allongés parallèles l'un à l'autre, engagés au moins en partie dans le résonateur et reliés au second conducteur coaxial (50).

8. Sonde selon la revendication 7, caractérisée par le fait que la boucle de prélèvement (40) peut pivoter autour d'un axe parallèle aux deux brins (43, 45).

9. Sonde selon la revendication 4, caractérisée par le fait que la boucle de prélèvement et la boucle d'adaptation sont constituées par un même seul enroulement (70) formé par deux spires ayant un point milieu (71).

10. Sonde selon la revendication 7, caractérisée par le fait que la boucle de prélèvement peut avoir un mouvement de translation sur un axe parallèle aux deux brins (43, 45).

## Claims

1. Nuclear magnetic resonance probe comprising at least one high frequency resonator (14, 16) containing at least one bottle (10, 12) having at least one radical solution (30), a first coaxial conductor (20) connected to the resonator and means for supplying said first coaxial conductor (20) at the resonant frequency of the resonator (14, 16), said probe being characterized in that the supply means are constituted by a conductive sampling loop (40) at least partly placed in the resonator (14, 16) and by a broad band, high frequency amplifier (56) having an input (E) connected to said loop (40) by a second coaxial conductor (50) and an output (S) connected to said first coaxial conductor (20), the amplifier assembly (56), first coaxial conductor (20), resonator (14, 16), sampling loop (40), second coaxial conductor (50) constituting a loop oscillator locked to the resonant frequency of the resonator (14, 16).

2. Probe according to claim 1, characterized in that the supply means also comprise means (58) for the automatic control of the gain of the amplifier (56).

3. Probe according to claim 1, characterized in that the supply means also comprise phase shifting means (54) inserted between the second coaxial conductor (50) and the input (E) of the amplifier (56).

4. Probe according to any one of the claims 1 to 3, characterized in that the bottle comprises an internal cylindrical tube (4) and an external wall (10), the resonator being formed on the one hand by a conductive core (16) occupying the internal tube (12) of the bottle and on the other hand by a conductive coating (14) deposited on the external wall of the bottle, the conductive core (16) and the conductive coating (14) being connected, on one side of the probe, to at least one fuming capacitor (18) and, on the other hand, to the first coaxial conductor (20) by an impedance matching loop 24.

5. Probe according to claim 4, characterized in that the sampling loop (40) is placed between the conductive core (16) and the internal tubes (12) of the bottle.

6. Probe according to claim 4, characterized in that the sampling loop (40) is placed in a tube (41) penetrating the radical solution between the cylindrical internal tube (12) and the external wall (10).

7. Probe according to any one of the claims I to 6, characterized in that the sampling loop (40) is formed by two elongated, parallel conductive strands (43, 45) at least partly engaged in the resonator and connected to the second coaxial conductor (50).

8. Probe according to claim 7, characterized in that the sampling loop (40) can pivot about an axis parallel to the two strands (43).

9. Probe according to claim 4, characterized in that the sampling loop and the matching loop are constituted by the same winding (70) formed by two turns having a centre (71).

10. Probe according to claim 7, characterized in that the sampling loop can have a translation movement on an axis parallel to the two strands (43, 45).

## Patentansprüche

1. Magnetische Kernresonanz-Sonde, umfassend:
- wenigstens einen Hochfrequenzresonator (14, 16) mit wenigstens einem Kolben (10, 12) mit wenigstens einer radikalartigen Lösung (30),
- einen ersten, mit dem Resonator verbundenen Koaxialleiter (20), und
- Versorgungseinrichtungen dieses ersten Koaxialleiters (20) mit der Resonanzfrequenz des Resonators (14, 16),
wobei diese Sonde **dadurch gekennzeichnet** ist, daß die Versorgungseinrichtungen gebildet werden durch eine leitende Entnahmespule (40), die wenigstens teilweise in dem Resonator (14, 16) angeordnet ist, und einen Breitband-Hochfrequenzverstärker (56) mit einem Eingang (E), der durch einen zweiten Koaxialleiter (50) mit der genannten Schleife (40) verbunden ist, und einen Ausgang (S), verbunden mit dem ersten Koaxialleiter (20), wobei die Anordnung aus Verstärker (56) , erstem Koaxialleiter (20) , Resonator (14, 16), Entnahmespule (40) und zweitem Koaxialleiter (50) einen durch die Resonanzfrequenz des Resonators (14, 16) gesteuerten Oszillator-Regelkreis bildet.

2. Sonde nach Anspruch 1, dadurch gekennzeichnet, daß die Versorgungseinrichtungen außerdem Einrichtungen (58) zur automatischen Kontrolle der Verstärkung des Verstärkers (56) umfassen.

3. Sonde nach Anspruch 1, dadurch gekennzeichnet, daß die Versorgungseinrichtungen außerdem Phasenverschiebungseinrichtungen (54) umfassen, eingeschaltet zwischen den zweiten Koaxialleiter (50) und den Eingang (E) des Verstärkers (56).

4. Sonde nach einem der Ansprüche 1 bis 3, dadurch gekennzeichnet, daß der Kolben ein zylindrisches Innenrohr (12) und eine Außenwand (10) umfaßt, wobei der Resonator einerseits durch einen leitenden Kern 16 gebildet wird, der das Innenrohr (12) des Kolbens einnimmt, und andererseits durch eine leitende Schicht (14), abgeschieden aur der Außenwand des Kolbens, wobei der leitende Kern (16) und die leitende Schicht (14) auf der einen Seite der Sonde mit wenigstens einem Kondensator verbunden ist und auf der anderen, über eine Impedanzanpassungsschleife (24), mit dem ersten Koaxialleiter (20).

5. Sonde nach Anspruch 4, dadurch gekennzeichnet, daß die Entnahmespule (40) zwischen dem leitenden Kern (16) und dem Innenrohr (12) des Kolbens angeordnet ist.

6. Sonde nach Anspruch 4, dadurch gekennzeichnet, daß die Entnahmespule (40) in einem Rohr (41) angeordnet ist, das in-die radikalartige Lösung zwischen dem zylindrischen Innenrohr (12) und der Außenwand (10) eindringt.

7. Sonde nach einem der Ansprüche 1 bis 6, dadurch gekennzeichnet, daß die Entnahmespule (40) durch zwei leitende Adern (43, 45) gebildet wird, die sich parallel zueinander erstrecken, wenigstens teilweise in den Resonator eingeführt und mit dem zweiten Koaxialleiter (50) verbunden.

8. Sonde nach Anspruch 7, dadurch gekennzeichnet, daß die Entnahmeschleife (40) um eine zu den beiden Adern (43, 45) parallele Achse schwenken kann.

9. Sonde nach Anspruch 4, dadurch gekennzeichnet, daß die Entnahmeschleife und die Adaptionsschleife durch dieselbe Wicklung (70 gebildet werden, die einen Mittelpunkt (71) umfaßt.

10. Sonde nach Anspruch 7, dadurch gekennzeichnet, daß die Entnahmeschleife einen Translationsbewegung auf einer zu den beiden Adern (43, 45) parallelen Achse ausführen kann.
